(19) **Europäisches Patentamt / European Patent Office / Office européen des brevets**

(11) **EP 1 542 499 B1**

(12) **EUROPEAN PATENT SPECIFICATION**

(45) Date of publication and mention
of the grant of the patent:
**27.07.2011 Bulletin 2011/30**

(51) Int Cl.:
**H04R 17/00** (2006.01)

(21) Application number: **04027336.9**

(22) Date of filing: **17.11.2004**

(54) **Acoustic vibration generating element**

Element zur Erzeugung von akustischen Schwingungen

Elément pour produire des vibrations acoustiques

(84) Designated Contracting States:
**DE FI FR GB**

(30) Priority: **12.12.2003 JP 2003414064**

(43) Date of publication of application:
**15.06.2005 Bulletin 2005/24**

(73) Proprietor: **Nec Tokin Corporation
Sendai-shi,
Miyagi (JP)**

(72) Inventor: **Tamura, Mitsuo
Taihaku-ku
Sendai-shi
Miyagi (JP)**

(74) Representative: **Hofer, Dorothea et al
Prüfer & Partner GbR
Patentanwälte
Sohnckestrasse 12
81479 München (DE)**

(56) References cited:
**GB-A- 1 277 912       US-A- 3 030 456
US-A- 5 411 467**

**Description**

Background of the Invention:

This invention relates to an acoustic vibration generating element. In particular, this invention is suitable for a bone conduction device, such as a bone conduction speaker, for converting an acoustic electric signal into acoustic vibration to be transmitted to a part of a human body, such as a cranial bone or an arm, so that an acoustic sound is sensed by an auditory nerve.

Heretofore, as an electromechanical transducer for a bone conduction device, use is predominantly made of an electromagnetic type. The electromechanical transducer of the electromagnetic type utilizes a principle same as that of a dynamic speaker and converts a driving force generated by interaction between an electric current flowing through a coil and a magnet into mechanical vibration. The electromechanical transducer of the type is disclosed, for example, in Japanese Patents (JP-B) Nos. 2967777 (corresp. to US Patent No. 6,141,427) and 3358086 (corresp. to US Patent No. 6,668,065).

However, the electromechanical transducer of the electromagnetic type is disadvantageous in the following respects. The electromechanical transducer of the electromagnetic type generates an electromagnetic force and therefore requires the electric current. When the electric current flows through the coil, an energy loss inevitably occurs by a resistance of the coil. Thus, most of energy supplied from a power source is dissipated at the coil as Joule heat and only about 1 % of the energy is used as acoustic energy. Further, in a low-frequency region, the electric current tends to be excessive because of low impedance so that a load upon the power source is increased. As a result, a sound output level is inevitably limited in the low-frequency region. Thus, in the low-frequency region, the sound output level tends to be insufficient.

On the other hand, proposal is made of a transducer for a bone conduction device, i.e., a bone conduction transducer which uses a piezoelectric element, although in a minority. The bone conduction transducer using the piezoelectric element comprises, as an acoustic vibration generating element, a piezoelectric unimorph element which is often used as a piezoelectric sound generator. The piezoelectric unimorph element comprises a metal plate and a piezoelectric plate adhered thereto. The bone conduction transducer of the type is disclosed, for example, in Japanese Patent Application Publications (JP-A) Nos. S59-140796 and S59-178895.

However, the bone conduction transducer using the piezoelectric element is disadvantageous in the following respects. Specifically, the bone conduction transducer using the piezoelectric element has a resonance frequency of 1 kHz or more if the bone conduction transducer has a practical size. Therefore, reproduction in the low-frequency region lower than the resonance frequency is insufficient. Further, since a mechanical quality factor Q of a vibrating system is high, generation of vibration is emphasized or attenuated at a specific frequency. In this event, sound reproduction can not naturally and normally be carried out.

As an example of the bone conduction device, there is also provided a bone conduction speaker not for a hearing-impaired person but for an unimpaired person. The bone conduction speaker of the type is required to prevent a reproduced sound from leaking to others except a user. However, with a known structure of the bone conduction speaker, vibration of a vibration source propagates to a structural member. As a result, the vibration of the structural member is propagated to the surroundings as the reproduced sound.

In bone conduction applications of the piezoelectric element, a resonance frequency of the piezoelectric element must be as low as possible if the low-frequency region is regarded as important. In order to lower the resonance frequency of the piezoelectric element, the following techniques A to C are proposed.

    A. To increase a diameter or a length of the piezoelectric element, which determines a vibration mode.
    B. To lower a flexural modulus K of the piezoelectric element.
    C. To add a mass to an antinode of vibration.

However, if an object equipped with the piezoelectric element is a portable apparatus such as a mobile phone and, therefore, the size of the piezoelectric element is restricted, the technique A has limitations.

The technique B is achieved by reducing the thickness of a piezoelectric ceramics sheet in case of a piezoelectric unimorph element and by reducing the thickness of a metal plate (shim plate) interposed between two piezoelectric ceramics sheets in case of a piezoelectric bimorph element. However, in this technique, the mechanical strength of the piezoelectric element is lowered. In addition, the weight of the piezoelectric element itself is decreased so that the resonance frequency is increased. Therefore, no substantive effect is obtained. Alternatively, by selecting an organic material having a small elastic modulus as the shim plate, the flexural modulus K can be lowered to some extent. However, the organic material generally has a small specific gravity so that the weight of a whole of the piezoelectric element is decreased. Therefore, the resonance frequency tends to be increased.

The technique C of adding the mass is disadvantageous in that the mechanical strength tends to be weakened against shocking vibration.

In a piezoelectric transducer such as the above-mentioned bone conduction transducer using the piezoelectric element, mechanical vibration is driven by piezoelectric distortion which is caused by an electric voltage. Therefore, the piezoelectric transducer is not accompanied with dissipation of Joule heat by the coil in the above-mentioned electromechanical transducer of the electromagnetic type. Therefore, it is possible to achieve energy saving. In addition, since metal components such as a magnet and a yoke are not required, a light weight and a thin profile can be achieved. Thus, the piezoelectric transducer has many advantages. In order to fully enjoy those advantages, the piezoelectric transducer is required to overcome the disadvantages such as a high resonance frequency and a high mechanical quality factor Q.

On the other hand, prevention of sound leakage to the surroundings is an unavoidable issue in order to bring the bone conduction speaker into practical use, whether electromagnetic or piezoelectric. In order to further exhibit the characteristics of the piezoelectric transducer, an input driving voltage is preferably suppressed as low as possible. In this event, energy loss of a driving circuit combined with the piezoelectric transducer is advantageously suppressed.

Further, the bone conduction speaker is generally attached to a human head when it is used. Therefore, it is desired for a user that the bone conduction speaker is light in weight and is easily wearable.

GB 1 277 912 discloses a bone conduction piezo-electric microphone or receiver comprising a thin disc 1 of piezoelectric material, e.g. a mixture of lead and zirconium titanate, with gold nichrome or silver electrodes 2, 3. The disc is bonded to a metal disc 6 having an acoustic stiffness equal to that of the disc 1 or to a second piezo-electric disc. The discs are polarized by the application of a high voltage and are then bonded together with opposite polarity or the same polarity. The transducer element may be encapsulated in a rubber sheath and is adapted to be retained by a harness in close proximity to the forehead or cheek. The effect of external noise may be reduced by thickening the coating on the rear of the unit. The transducer may also be used in an ear insert microphone with the element either spring loaded against the side of the ear canal or enclosed in a resilient plastics housing having a driving pip.

Summary of the Invention:

It is therefore an object of this invention to achieve a lower resonance frequency, a lower mechanical quality factor Q, and suppression of sound leakage in a bone conduction device, in particular, a bone conduction speaker.

The object is attained by a bone conduction acoustic vibration generating element according to claim 1 or 4. Further developments of the invention are specified in the dependent claims, respectively.

Brief Description of the Drawing:

Fig. 1A is a perspective view of an acoustic vibration generating element in case where a piezoelectric element has opposite surfaces covered with a flexible material;
Fig. 1B is a perspective view of another acoustic vibration generating element in case where a piezoelectric element is entirely covered with a flexible material;
Fig. 2 is a sectional view of the acoustic vibration generating element in Fig. 1A in case where the piezoelectric element is a piezoelectric bimorph element;
Fig. 3 is a characteristic chart showing the change in resonance frequency of the acoustic vibration generating element in Fig. 2 when a silicone rubber as a covering member is changed in thickness;
Fig. 4 is a perspective view of a piezoelectric bimorph element having a laminated structure which may be used in this invention;
Fig. 5 is a characteristic chart showing a result of comparison of acceleration in an artificial internal ear between an acoustic vibration generating element covered with a flexible material according to a first example and an acoustic vibration generating element without being covered with the flexible material;
Fig. 6 is a characteristic chart showing a result of comparison of acceleration in an artificial internal ear between an acoustic vibration generating element covered with a flexible material according to a second example and an acoustic vibration generating element without being covered with the flexible material;
Fig. 7 is a perspective view of an acoustic vibration generating element according to a third example which is an embodiment of this invention in which V-shaped grooves are formed on a surface of a flexible material;
Fig. 8 is a view showing a result of comparison of acceleration in an artificial internal ear between the acoustic vibration generating element in Fig. 7 and an acoustic vibration generating element without the V-shaped grooves;
Fig. 9 is a sectional view of an acoustic vibration generating element according to a fourth example in which an air chamber is formed on one side of a flexible material;
Fig. 10 is a view showing an acoustic vibration generating element according to a fifth example in which a covering member of a flexible material and an earhook are integrally formed; and

Fig. 11 is a view showing the acoustic vibration generating element in Fig. 10 when it is attached to a human ear.

<u>Description of the Preferred Embodiments:</u>

Now, description will be made of this invention with reference to the drawing.

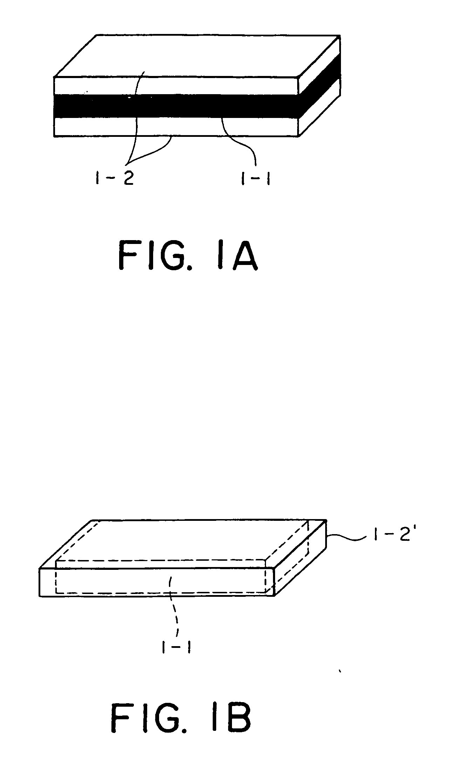

At first referring to Figs. 1A, 1B, 2, and 3, a basic structure and a principle of this invention will be described in detail.

Referring to Fig. 1A, an acoustic vibration generating element according to this invention comprises a piezoelectric bimorph element (or piezoelectric unimorph element) 1-1 and a pair of covering members 1-2 attached to two surfaces perpendicular to a thickness direction of the piezoelectric bimorph element 1-1.

Referring to Fig. 1B, another acoustic vibration generating element according to this invention comprises the piezoelectric bimorph element (or piezoelectric unimorph element) 1-1 entirely covered with a covering member 1-2'. The covering members 1-2 and 1-2' are made of a flexible material.

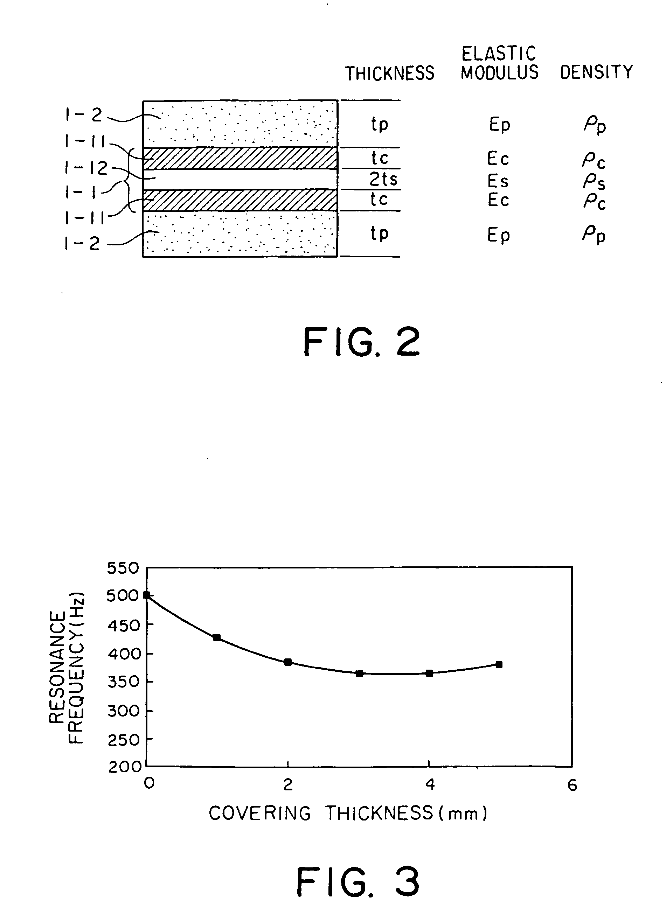

Referring to Fig. 2, the acoustic vibration generating element in Fig. 1A comprises the piezoelectric bimorph element 1-1 and the covering members 1-2 attached to opposite surfaces thereof, i.e., two surfaces perpendicular to the thickness direction of the piezoelectric bimorph element 1-1. The piezoelectric bimorph element 1-1 comprises two piezoelectric ceramics sheets 1-11 and a shim plate 1-12 interposed therebetween.

Referring to Fig. 2, the principle of this invention will be described. For convenience of description, it is assumed that the piezoelectric bimorph element 1-1 has a rectangular shape. The piezoelectric bimorph element 1-1 has a resonance frequency $F_r$ which is different depending upon a supporting structure. If opposite ends of the piezoelectric bimorph element 1-1 are free ends, the resonance frequency $F_r$ is given by the following Equation (1). In Equation (1), $\alpha$ is a value determined by a vibration mode and is equal to 4.73 in primary resonance. L represents a length of the piezoelectric bimorph element 1-1, K, a flexural modulus, $\rho S$, a weight per unit length.

$$F_r = \frac{\alpha^2}{2\pi L^2} \sqrt{\frac{K}{\rho S}} \qquad (1)$$

The flexural modulus K of the acoustic vibration generating element is determined by various factors such as the size and the material of each of the piezoelectric ceramics sheets 1-11 and the shim plate 1-12 forming the piezoelectric bimorph element 1-1, and the covering members 1-2. Specifically, the flexural modulus K is determined by the width w of each of the piezoelectric ceramics sheets 1-11 and the shim plate 1-12, the thickness $t_c$ and the elastic modulus $E_c$ of each of the piezoelectric ceramics sheets 1-11, the thickness $2t_s$ and the elastic modulus $E_s$ of the shim plate 1-12, and the thickness $t_p$ and the elastic modulus $E_p$ of each of the covering members 1-2 and is given by the following Equation (2).

$$K = \frac{2w}{3} \left\{ E_s t_s^3 + E_c (3t_s^2 t_c + 3t_s t_c^2 + t_c^3) + E_p (3t_s^2 t_p + 6t_s t_c t_p + 3t_c^2 t_p + 3t_s t_p^2 + 3t_c t_p^2 + t_p^3) \right\}$$

$$(2)$$

The weight $\rho S$ per unit length is determined by the thickness $t_c$, $2t_s$, and $t_p$ and the specific gravity $\rho_c$, $\rho_s$, and $\rho_p$ of each of the piezoelectric ceramics sheets 1-11, the shim plate 12, and the covering members 1-2 as well as the width w of the piezoelectric bimorph element 1-1 and is given by the following Equation (3).

$$\rho S = 2w(\rho_p t_p + \rho_c t_c + \rho_s t_s) \qquad (3)$$

When the covering member 1-2 as a new layer is added to each of the opposite surfaces of the piezoelectric bimorph element 1-1, the flexural modulus K and the weight $\rho S$ per unit length are changed so that the resonance frequency is affected. Depending upon the material selected as the covering members 1-2, the resonance frequency of the acoustic vibration generating element may become high. In most cases, however, the resonance frequency is lowered. Specifically, if the covering members are formed by a flexible material having an elastic modulus not greater than a predetermined value, for example, a rubber having a small elastic modulus of $3 \times 10^6$ Pa to $8 \times 10^6$ Pa, the flexural modulus K of a whole of the acoustic vibration generating element is increased by addition of the new layer. However, an increasing rate of the flexural modulus K is small as compared with an increasing rate of the weight $\rho S$ per unit length. As a result, the resonance frequency of the acoustic vibration generating element is lowered.

Fig. 3 shows the change in resonance frequency when a silicone rubber is used as the flexible material and a covering thickness of the flexible material is changed. From Fig. 3, it is understood that the flexible material has an effect of lowering the resonance frequency and simultaneously lowering the mechanical quality factor Q so that a frequency range is widened. Consideration will be made of an acoustic output of the acoustic vibration generating element as a bone conduction speaker. As the acoustic vibration generating element radiates acoustic energy in tight contact with a human skin, such a structure that the piezoelectric element is covered with the flexible material is suitable in view of acoustic impedance matching between the acoustic vibration generating element and the human skin. In particular, in case where the piezoelectric bimorph element is covered with the flexible material, an effect of suppressing sound leakage, i.e., radiation of unnecessary sound to the surroundings is achieved.

In the foregoing, description has been directed to the case where the acoustic vibration generating element has a rectangular shape. It is noted here that the similar effect is obtained in case where a piezoelectric bimorph or unimorph element of a circular shape is used.

Hereinafter, this invention will be described in conjunction with several preferred embodiments.

First Example

[Piezoelectric Bimorph Element of a Rectangular Shape]

Preparation was made of a piezoelectric bimorph element having a rectangular shape and comprising two piezoelectric ceramics sheets (manufactured by NEC Tokin under the trade name of NEPEC10®) having the length of 32 mm, the width of 8 mm, and the thickness of 0.15 mm and a shim plate of brass having the length and the width equal to those of the piezoelectric ceramics sheets and the thickness of 50 $\mu$m. The piezoelectric bimorph element has a structure in which the shim plate is adhered between the two piezoelectric ceramics sheets by the use of an epoxy adhesive. Hereinafter, the above-mentioned structure will be called a single-plate structure.

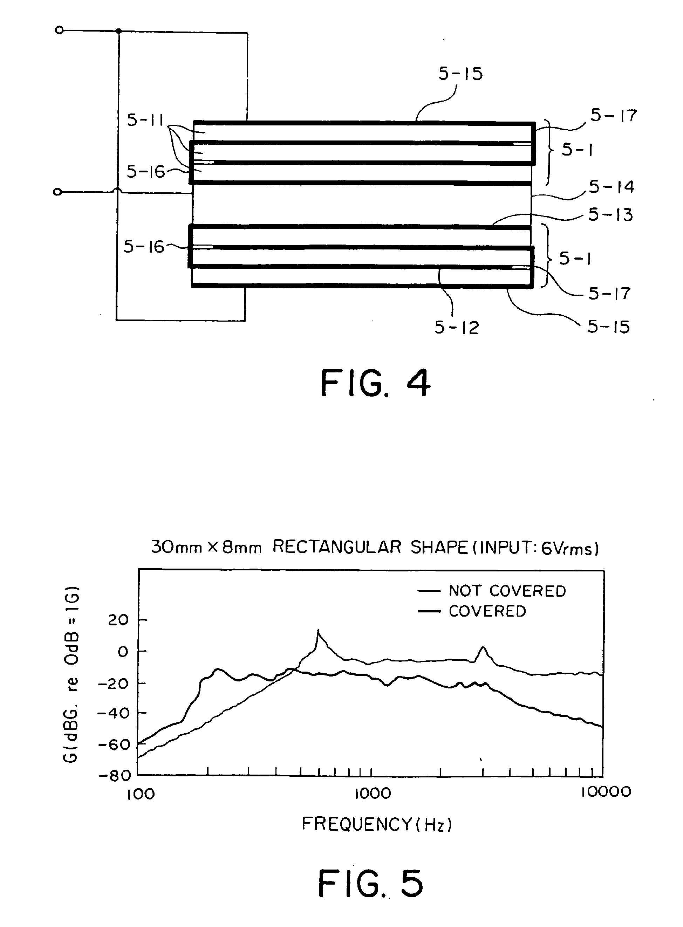

On the other hand, as illustrated in Fig. 4, another piezoelectric bimorph element was produced in the following manner. Preparation was made of two sets of laminated piezoelectric ceramics members 5-1. Each of the laminated piezoelectric ceramics members 5-1 comprises three piezoelectric ceramics sheets 5-11 and two internal electrodes 5-12 interposed between adjacent ones of the piezoelectric ceramics sheets 5-11. Each of the piezoelectric ceramics sheets 5-11 is made of a material same as that of the above-mentioned piezoelectric ceramics sheet and having the length and the width equal to those of the above-mentioned piezoelectric ceramics sheet and a thickness of 50 $\mu$m. Between the two sets of the laminated piezoelectric ceramics members 5-1, a metal shim plate 5-14 is interposed through internal electrodes 5-13. Each of the laminated piezoelectric ceramics members 5-1 has an outer surface provided with an external electrode 5-15. A first one of the internal electrodes 5-12 is connected to the internal electrode 5-13 via a side surface electrode 5-16. A second one of the internal electrodes 5-12 is connected to the external electrode 5-15 via a side surface electrode 5-17. In the following, the above-mentioned structure will be called a laminated structure. The above-mentioned structure will hereinafter be called a laminated structure.

In case of the piezoelectric bimorph element of the single-plate structure, lead wires are connected to outer surfaces of the shim plate and the piezoelectric ceramics sheets on opposite outermost surfaces through the electrodes so that, when an electric field is applied to one of the piezoelectric ceramics sheets in a direction same as a polarization direction, a reverse electric field is applied to the other piezoelectric ceramics sheet. Similarly, in case of the piezoelectric bimorph element of the laminated structure, lead wires are connected so that, when an electric field is applied to one of the piezoelectric ceramics sheets in the direction same as the polarization direction, a reverse electric field is applied to another piezoelectric ceramics sheet adjacent thereto.

Next, by the use of a brass die, a solution of silicone rubber as the flexible material was poured over an entire surface of the piezoelectric bimorph element. By a setting or curing process, acoustic vibration generating elements of a single-plate structure and a laminated structure were produced. Each of the acoustic vibration generating elements was provided with rubber covering having the thickness of 2 mm on two surfaces perpendicular to the thickness direction and the thickness of 1 mm on remaining surfaces.

When the acoustic vibration generating element of the single-plate structure was supplied with an acoustic signal of about 18 Vrms and one surface of the acoustic vibration generating element was pressed against a user's head, a clear sound by bone conduction was confirmed. The acoustic vibration generating element of the laminated structure produced an output of the equivalent level in response to an input of about 6 Vrms corresponding to 1/3 as compared with the single-plate structure.

Further, in order to evaluate a leaking sound, a sound pressure of 100 Hz to 10 kHz was measured at a distance of 50 cm in an anechoic chamber. As a result, it has been confirmed that, in each of the single-plate structure and the laminated structure, a sound pressure level was not greater than 50 dB. Thus, sound leakage was very small.

Next, in order to quantitatively confirm acoustic effects of the flexible material, an artificial internal ear (Artificial Mastoid Type 4930 manufactured by B & K) was used to measure and compare accelerations at a position corresponding to an auditory nerve of a human body before and after covering with the flexible material. It is noted that the magnitude of acceleration in the internal ear is proportional to the strength of the acoustic signal received by the auditory nerve.

Fig. 5 shows a result of comparison of acceleration (G) in the artificial internal ear. As is obvious from Fig. 5, it has been confirmed that, in case of the acoustic vibration generating element covered with the flexible material, the acceleration is improved in an output in a low-frequency region and the sharpness of a resonant portion is considerably alleviated.

Second Example

[Piezoelectric Bimorph Element of a Circular Shape]

Preparation was made of a piezoelectric bimorph element having a circular shape and comprising two piezo-electric ceramics sheets (manufactured by NEC Tokin under the trade name of NEPEC10®) having the diameter of 30 mm and the thickness of 0.15 mm and a shim plate of brass having the diameter equal to that of the piezoelectric ceramics sheets and the thickness of 50 $\mu$m. The piezoelectric bimorph element has a structure in which the shim plate is adhered between the two piezoelectric ceramics sheets by the use of an epoxy adhesive. Hereinafter, the above-mentioned structure will be called a single-plate structure.

By the use of piezoelectric ceramics sheets made of a material same as the above-mentioned piezoelectric ceramics sheets and having the same diameter and the thickness of 50 $\mu$m, a circular piezoelectric bimorph element of a laminated structure was prepared in the manner similar to that described in conjunction with Fig. 4.

Wire connection was carried out in the manner similar to the first embodiment.

Next, by the use of a brass die, a solution of silicone rubber was poured over an entire surface of the piezoelectric bimorph element. By a setting or curing process, acoustic vibration generating elements of a single-plate structure and a laminated structure were produced. Each of the acoustic vibration generating elements was provided with rubber covering having the thickness of 2 mm on opposite surfaces perpendicular to the thickness direction and the thickness of 1 mm on remaining surfaces.

The acoustic vibration generating element of the single-plate structure and the acoustic vibration generating element of the laminated structure were supplied with acoustic signals of about 18 Vrms and about 6 Vrms, respectively. One surface of each of the acoustic vibration generating elements was pressed against a user's head. As a result, a clear sound by bone conduction was confirmed.

Further, in order to evaluate a leaking sound, a sound pressure of 100 Hz to 10 kHz was measured at a distance of 50 cm in an anechoic chamber. As a result, it has been confirmed that, in each of the single-plate structure and the laminated structure, a sound pressure level was not greater than 50 dB. Thus, sound leakage was very small.

Next, in order to quantitatively confirm acoustic effects of the flexible material, an artificial internal ear (Artificial Mastoid Type 4930 manufactured by B & K) was used to measure and compare accelerations at a position corresponding to an auditory nerve of a human body before and after covering with the flexible material. It is noted that the magnitude of acceleration in the internal ear is proportional to the strength of the acoustic signal received by the auditory nerve.

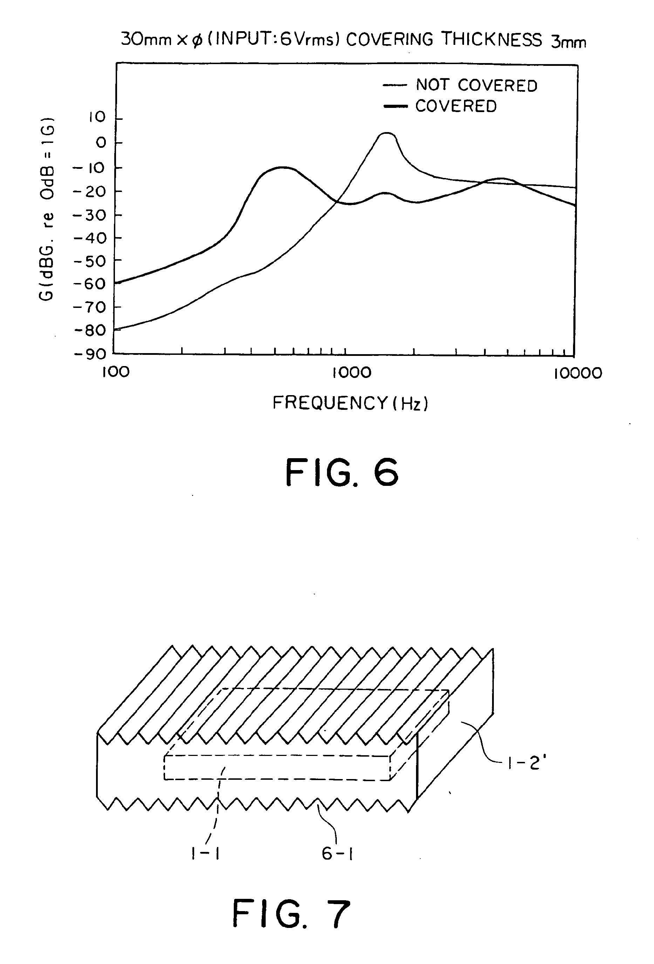

Fig. 6 shows a result of comparison of acceleration (G) in the artificial internal ear. As is obvious from Fig. 6, it has been confirmed that, in case of the acoustic vibration generating element covered with the flexible material, the acceleration is improved also in a low-frequency region and the sharpness of a resonant portion is considerably alleviated. The effects of lowering the resonance frequency, decreasing the mechanical quality factor Q, and preventing sound leakage by the flexible material can be achieved not only by molding the silicone rubber as the flexible material but also by adhering the flexible material to a surface of the piezoelectric element.

Third Example

[Covering member with V-shaped Grooves on Its Surface]

The acoustic vibration generating element experimentally prepared in the first example was subjected to mechanical machining to form a plurality of V-shaped grooves on two principal surfaces of the covering member of the flexible material (silicone rubber in the embodiment). Each of the V-shaped grooves has a depth of 0.6 mm and extends in a direction perpendicular to a lengthwise direction. Thus, an acoustic vibration generating element according a third example which is an embodiment of this invention was produced.

Fig. 7 shows the acoustic vibration generating element according to the third embodiment. The piezoelectric bimorph element 1-1 is covered with the covering member 1-2'. The covering member 1-2' is provided with a plurality of V-shaped grooves 6-1 on its two principal surfaces.

The acoustic vibration generating element illustrated in Fig. 7 was subjected to measurement using the artificial internal ear in the manner similar to that described in conjunction with the foregoing embodiments.

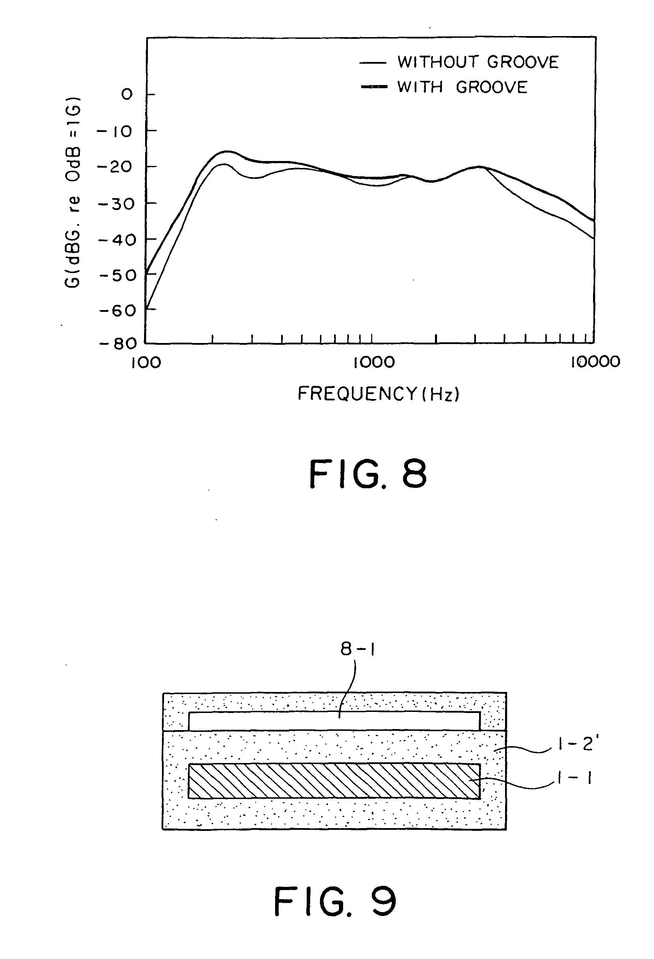

Fig. 8 shows the result of comparison of acceleration (G) in the artificial internal ear. As is obvious from Fig. 8, the acoustic vibration generating element having the V-shaped grooves has an acceleration slightly greater than that of the acoustic vibration generating element without the V-shaped grooves. The sound leakage had an equivalent level. This is because the presence of the V-shaped grooves facilitates bending and deformation so that the flexural modulus K is apparently decreased, resulting in an increase in generated force and in output level. Further, the output level is increased in a low frequency region. This is an effect similarly obtained by the decrease in flexural modulus K. Specifically, as will be understood from Equation (1), the resonance frequency $F_r$ is lowered due to the decrease in flexural modulus K. The shape of the grooves formed on the surface of the covering member is not limited to the V shape. The similar effect is obtained by the grooves having semicircular section or any other appropriate shape.

Fourth Example

[Covering member with Air Chamber formed on One Side]

To one surface of the acoustic vibration generating element experimentally prepared in the second example, a circular ring of soft rubber (having the outer diameter of 30 mm, the inner diameter of 25 mm, and the thickness of 1 mm) equal in diameter to the acoustic vibration generating element and a circular plate (having the diameter of 30 mm and the thickness of 1 mm) of the same material were successively adhered by the use of a rubber-based adhesive. Thus, an air chamber having the diameter of 25 mm and the thickness of 1 mm was formed on one side of the acoustic vibration generating element. Thus, an acoustic vibration generating element according to a fourth example was produced.

Fig. 9 shows the acoustic vibration generating element according to the fourth embodiment. The piezoelectric bimorph element 1-1 is covered with the covering member 1-2' of the flexible material. On one side of the acoustic vibration generating element, the air chamber 8-1 is formed. An output surface, i.e., the other side of the acoustic vibration generating element without the air chamber 8-1 was pressed against a part of a user's head and an acoustic signal was supplied. By presence of the air chamber 8-1, sound leakage from an opening surface on the one side is reduced.

In this embodiment, the air chamber 8-1 was formed by the rubber ring and the circular plate. Not being limited thereto, the air chamber may be formed in any other appropriate manner, for example, may be formed integrally with the covering member. Even in a structure such that the air chamber is connected to external air in the process of molding, the similar effect is obtained. As will readily be understood, the above-mentioned effect is obtained not in the piezoelectric bimorph element of a circular shape but also in the piezoelectric bimorph element of a rectangular shape similar to that described in the first example.

Fifth Example

[Covering member and Ear Hook are Integrally Molded by Flexible Material]

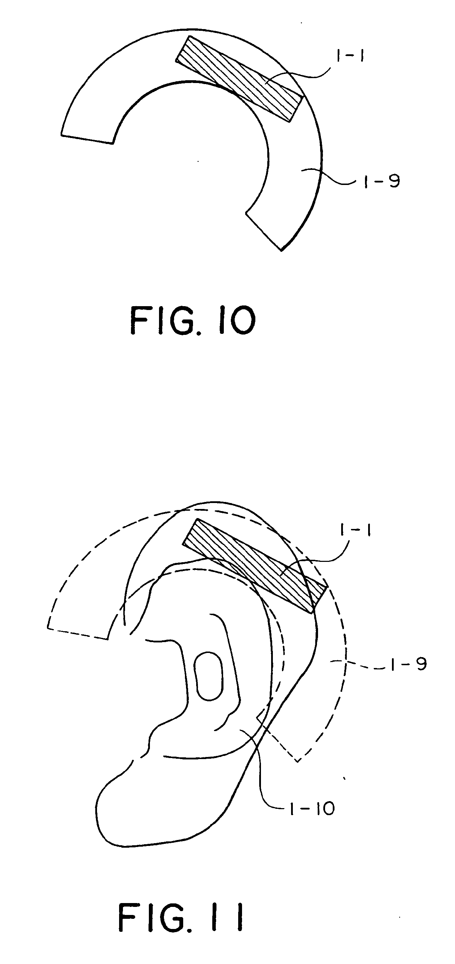

Fig. 10 shows an acoustic vibration generating element comprising the piezoelectric bimorph element 1-1 experimentally produced in the first embodiment and an ear hook 1-9 and the covering member are integrally molded by a covering silicone rubber.

Fig. 11 shows a state where the acoustic vibration generating element in Fig. 10 is attached to a human ear 1-10. As illustrated in Fig. 11, the acoustic vibration generating element is attached to the human ear 1-10. When an electric signal is supplied, a cartilage of an external ear and a cranial bone behind the ear are simultaneously stimulated so that a sound by bone conduction can be sensed more clearly.

Each of the first through the fifth examples has been described in connection with the acoustic vibration generating element in which a whole of the piezoelectric bimorph element is covered with the covering member. However, the similar effect is obtained in an acoustic vibration generating element in which the piezoelectric bimorph element is covered with the covering member on at least two surfaces perpendicular to the thickness direction thereof. Of course, this applies to the piezoelectric unimorph element.

As described above, this invention provides the acoustic vibration generating element which is capable of lowering the resonance frequency, decreasing the mechanical quality factor Q, and preventing the sound leakage. The acoustic vibration generating element has a robust and light-weight structure and has a wide frequency range. Therefore, the acoustic vibration generating element according to this invention is suitable for a bone conduction device, in particular, to a bone conduction speaker.

**Claims**

1. A bone conduction acoustic vibration generating element comprising a piezoelectric bimorph or unimorph element (1-1) and covering members (1-2) made of a flexible material and attached to at least two surfaces perpendicular to a thickness direction of the piezoelectric bimorph or unimorph element,
   **characterized in that**
   each of the covering members is provided with a plurality of grooves (6-1) formed on its surface.

2. The bone conduction acoustic vibration generating element according to claim 1, wherein the piezoelectric bimorph element has a laminated structure comprising piezoelectric ceramics sheets (5-11) and internal electrodes (5-12, 5-13).

3. The bone conduction acoustic vibration generating element according to claim 1 or 2, further comprising an earhook portion (1-9) made of the flexible material and integrally formed with the covering member.

4. A bone conduction acoustic vibration generating element comprising a piezoelectric bimorph or unimorph element (1-1) and a covering member (1-2') made of a flexible material and covering a whole of the piezoelectric bimorph element or the piezoelectric unimorph element,
   **characterized in that**
   the covering member is provided with a plurality of grooves (6-1) formed on its surface.

5. The bone conduction acoustic vibration generating element according to claim 4, wherein the piezoelectric bimorph element has a laminated structure comprising piezoelectric ceramics sheets (5-11) and internal electrodes (5-12, 5-13).

6. The bone conduction acoustic vibration generating element according to claim 4 or 5, further comprising an earhook portion (1-9) made of the flexible material and integrally formed with the covering member.

**Patentansprüche**

1. Akkustisches Knochenleitungsschwingungserzeugungselement mit einem bimorphen oder unimorphen piezoelektrisches Element (1-1) und Abdeckelementen (1-2), die aus einem flexiblen Material bestehen und an zumindest zwei Oberflächen angebracht sind, die senkrecht zu einer Dickenrichtung des bimorphen oder unimorphen piezoelektrischen Elements sind,
   **dadurch gekennzeichnet, dass**
   jedes Abdeckelement mit einer Mehrzahl von Gräben (6-1) versehen ist, die an seiner Oberfläche gebildet sind.

2. Akkustisches Knochenleitungsschwingungserzeugungselement gemäß Anspruch 1, bei dem das bimorphe piezoelektrische Element einen geschichteten Aufbau hat, der piezoelektrische Keramikblätter (5-11) und interne Elektroden (5-12, 5-13) aufweist.

3. Akkustisches Knochenleitungsschwingungserzeugungselement gemäß Anspruch 1 oder 2, das weiter einen Ohrhakenabschnitt (1-9) enthält, der aus dem flexiblen Material besteht und integral mit dem Abdeckelement gebildet ist.

4. Akkustisches Knochenleitungsschwingungserzeugungselement mit einem bimorphen oder unimorphen piezoelektrisches Element (1-1) und einem Abdeckelement (1-2'), das aus einem flexiblen Material besteht und das gesamte bimorphe piezoelektrische Element oder unimorphe piezoelektrische Element bedeckt,
   **dadurch gekennzeichnet, dass**
   das Abdeckelement mit einer Mehrzahl von Gräben (6-1) versehen ist, die an seiner Oberfläche gebildet sind.

5. Akkustisches Knochenleitungsschwingungserzeugungselement gemäß Anspruch 4, bei dem das bimorphe piezoelektrische Element einen geschichteten Aufbau hat, der piezoelektrische Keramikblätter (5-11) und interne Elektroden (5-12, 5-13) aufweist.

6. Akkustisches Knochenleitungsschwingungserzeugungselement gemäß Anspruch 4 oder 5, das weiter einen Ohrhakenabschnitt (1-9) enthält, der aus dem flexiblen Material besteht und integral mit dem Abdeckelement gebildet ist.

**Revendications**

1. Elément générateur de vibrations acoustiques à conduction osseuse comportant :

   un élément piézo-électrique (1-1) bimorphe ou monomorphe, et des éléments de couverture (1-2) en un matériau souple et fixés à au moins deux surfaces perpendiculaires à la direction de l'épaisseur de l'élément piézo-électrique bimorphe ou monomorphe,
   élément générateur **caractérisé en ce que**

   - chacun des éléments de couverture comporte au moins un ensemble de gorges (6-1) réalisées dans sa surface.

2. Elément générateur de vibrations acoustiques à conduction osseuse selon la revendication 1,
   **caractérisé en ce que**
   l'élément piézo-électrique bimorphe a une structure laminée formée de feuilles de céramique piézo-électrique (5-11) et d'électrodes internes (5-12, 5-13).

3. Elément générateur de vibrations acoustiques à conduction osseuse selon la revendication 1 ou 2,
   **caractérisé en ce qu'**
   il comporte en outre une partie formant un crochet auriculaire (1-9) en un matériau souple et réalisé en une seule pièce avec l'élément de recouvrement.

4. Elément générateur de vibrations acoustiques à conduction osseuse comportant un élément piézo-électrique (1-1) bimorphe ou monomorphe, ainsi qu'un élément de couverture (1-2') en un matériau souple et couvrant la totalité de l'élément piézo-électrique bimorphe ou de l'élément piézo-électrique monomorphe,
   **caractérisé en ce que**
   l'élément de couverture comporte un ensemble de gorges (6-1) formées dans sa surface.

5. Elément générateur de vibrations acoustiques à conduction osseuse selon la revendication 4,
   **caractérisé en ce que**
   l'élément piézo-électrique bimorphe a une structure laminée formée de feuilles de céramique piézo-électrique (5-11) et d'électrodes internes (5-12, 5-13).

6. Elément générateur de vibrations acoustiques à conduction osseuse selon la revendication 4 ou 5,
   **caractérisé en ce qu'**
   il comporte en outre une partie formant un crochet d'oreille (1-9) en un matériau souple et faisant corps avec l'élément de couverture.

I - 2          I - I

FIG. IA

I - 2'

I - I

FIG. IB

FIG. 2

FIG. 3

FIG. 4

30mm × 8mm RECTANGULAR SHAPE (INPUT: 6Vrms)

FIG. 5

30mm × φ (INPUT: 6Vrms) COVERING THICKNESS 3mm

FIG. 6

FIG. 7

FIG. 8

FIG. 9

EP 1 542 499 B1

I-I

I-9

FIG. IO

I-I

I-9

I-10

FIG. I I

15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6141427 A
- US 3358086 A
- US 6668065 B
- JP S59140796 A
- JP S59178895 A
- GB 1277912 A